(19) **Europäisches Patentamt / European Patent Office / Office européen des brevets**

(11) **EP 4 760 395 A1**

(12) **EUROPEAN PATENT APPLICATION**

(43) Date of publication:
**17.06.2026 Bulletin 2026/25**

(51) International Patent Classification (IPC):
**G03F 7/20** (2006.01)    **G06N 3/047** (2023.01)
**G06N 3/08** (2023.01)    **G06N 20/00** (2019.01)

(21) Application number: **24219103.9**

(22) Date of filing: **11.12.2024**

(52) Cooperative Patent Classification (CPC):
**G03F 7/705; G03F 7/706841; G06N 3/047;
G06N 3/08; G06N 3/084; G06N 3/0895; G06N 7/01;
G06N 20/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
- **RUIZ, Hans-Christian
  5500 AH Veldhoven (NL)**
- **PISARENCO, Maxim
  5500 AH Veldhoven (NL)**
- **ONOSE, Alexandru
  5500 AH Veldhoven (NL)**
- **VAN KRAAIJ, Markus, Gerardus, Martinus, Maria
  5500 AH Veldhoven (NL)**

(74) Representative: **ASML Netherlands B.V.
Corporate Intellectual Property
P.O. Box 324
5500 AH Veldhoven (NL)**

(54) **SOLVING INVERSE PROBLEMS VIA STOCHASTIC OPTIMAL CONTROL**

(57) A method of processing pattern data to data to generate description data is provided. The pattern data is informative about a patterned portion of a substrate, and the description data characterizes a model of the patterned portion of the substrate or of a lithographic apparatus operative to produce the patterned portion of the substrate. The method comprises i) obtaining the pattern data, ii) generating initial description data, and iii) at each of a plurality of iterations, updating the current description data by providing the current description data to an input of a trained controller module conditioned on the pattern data to generate first adjustment data to the current description data, randomly selecting second adjustment data to the current description data; and determining updated description data based on the current description data and the first and the second adjustment data.

## Fig. 9

**EP 4 760 395 A1**

**Description**

<u>FIELD</u>

The present invention relates to systems and methods for processing pattern data (such as observed data describing a patterned portion of a substrate (e.g. metrology data) and/or data relating to a target structure for the substrate) to generate description data (e.g. characterizing a model of the patterned portion of the substrate or of a lithographic apparatus operative to produce the patterned portion of the substrate). The present invention also relates to systems and methods of training a controller module to process description data, when the controller module is conditioned on pattern data, to generate first adjustment data for the description data in accordance with controller module parameters.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Many challenges in the manufacture of integrated circuits involve solving an "inverse problem", i.e. determining, from data describing a "target" (e.g. a desired output or an observation), causal factors that produced the target. Often the desired inverse solutions are hard to obtain because of a non-linear relationship between the causal factors and the target. Further, many relevant inverse problems are "ill-posed", i.e. having a solution space that is a manifold without well-defined global optima, or having global optima which are very difficult to find. For example, there may be a set of distinctly different, but equally valid solutions, or almost-equally albeit globally non-optimal solutions. Examples of these inverse problems are the reticle design optimization for a desired wafer pattern in inverse lithography, wafer surface depth estimation given an acquired SEM image, surface imaging using EUV ptychography, or geometry (profile) reconstruction using scatterometry.

Sometimes the inverse solution can be estimated by iteratively solving an optimization problem. In these cases, a (physics-derived or trained) forward model may be used (i.e. a simulation model that generates a prediction of the target from input parameters that define the candidates of the causal factors). The forward model is repeatedly used while varying (optimizing) the parameters in order to minimize the difference between the target and the prediction in some metric. The set of input parameters that give a sufficiently close match are considered to be a good indication of the causal factors of the target. During the optimization process, the parameter values can be selected (i.e. varied) in different ways, e.g. by random sampling or by using a mathematical optimization algorithm. The selection strategy is often chosen based on the characteristics of the forward model and the parameter space. Some known algorithms use prior knowledge of the parameter space.

However, iterative optimization based on forward models is prone to getting stuck in local minima of a cost function being used, and computationally intensive because of the repeated evaluations by the forward model. It is therefore desirable to provide improved techniques for solving inverse problems in the manufacture of integrated circuits.

## SUMMARY

The present invention aims to provide new and useful methods and systems for processing pattern data to generate description data. The pattern data is informative about (e.g. describes) a patterned portion of a substrate (e.g. the pattern data may comprise acquired metrology data of the patterned portion of a substrate, or design data of a pattern/structure applicable to a portion of a substrate by a lithographic apparatus). The description data characterizes a model of the patterned portion of the substrate (e.g. when the pattern data comprises metrology data) or of a lithographic apparatus operative to produce the patterned portion of the substrate (e.g. when the pattern data comprises data describing the lithographic apparatus). The generated description data may be considered to represent "causal factors" of the pattern data. That is, the generated description may be considered to represent a solution to an inverse problem associated with the pattern data, i.e. there may exist a "forward" process, in which a physical system configured according to the generated description data generates the pattern data.

In general terms, the invention proposes a method of processing pattern data to generate description data by implementing a stochastic process in which an initial guess of the description data is iteratively updated. In each iteration, the description data is both randomly perturbed and guided towards a solution of the inverse problem.

More specifically, the method comprises obtaining the pattern data, generating initial description data and at each of a plurality of iterations, updating the current description data by providing the current description data to an input of a trained controller module conditioned on the pattern data to generate first adjustment data to the current description data, randomly selecting second adjustment data to the current description data (the initial description data may be generated based on the pattern data, or may be randomly selected), and determining updated description data based on the current description data and the first and the second adjustment data.

As described in more detail below, the controller module is a computational model that has been trained to generate first adjustment data that "guides" the description data towards values that lower values of an appropriate objective function (e.g. towards a global minimum of the objective function). An advantage of the proposed method is that the proposed method can overcome local minima of the objective function by "tunnelling" through high cost regions (since the implemented stochastic process is a non-greedy approach). This 'tunnelling effect' results in a better exploration of the solution space and the ability to target multi-mode or complex shaped solution distributions. Another advantage of the proposed method is that the method does not require gradient information of the objective function (neither during the proposed method nor during training of the controller module, as described in more detail further below).

In some implementations, determining updated description data based on the first and second adjustment data may comprise determining the updated data by additively combining (i) a function of the first adjustment data, (ii) a function of the second adjustment data and (iii) a function of the current description data. For example, the updated description data may be determined by additively combining the current description data with the first and the second adjustment data.

In some implementations, randomly selecting second adjustment data to the current description data may comprise sampling a random number (i.e. sampling from a distribution to generate a random number), and determining the second adjustment data based on the random number and based on the current description data.

In some implementations, the trained controller module may be conditioned on the pattern data, on the current description data and on a variable indicating the iteration. Optionally, in these situations, the controller module may be defined by a plurality of parameters, and the method may further comprise, at each iteration, determining, based on the variable indicating the iteration, current values of the plurality of parameters. In other implementations, the trained controller module is not explicitly conditioned on the variable indicating the iteration. Note that in general, an iteration-independent (or "time-independent") control function is normally simpler to learn than an iteration-dependent (or "time-dependent") control function, though it may require more training data.

In some implementations, the pattern data may specify a desired target structure, and the generated description data characterizes a model of a component of the lithographic apparatus for patterning a portion of a substrate to form the target structure (the component may be a mask of the lithographic apparatus for patterning a portion of a substrate to form the target structure). In these situations, the method may further comprise a step of outputting computer executable instructions for manufacturing a component of the lithographic apparatus based on the generated description data. Preferably, the method may further comprise a step of forming the component for the lithographic apparatus based on the generated description data.

Alternatively, the pattern data may comprise metrology data (e.g. comprising image data, such as image data obtained using optical metrology) of the patterned portion, and the generated description data may specify predicted information characterizing the patterned portion (e.g. a depth map of the patterned portion).

The controller module may be implemented in several ways. For example, in some implementations, the controller module may implement a parametrized linear feedback controller. Alternatively, the controller module may comprise at least one neural network.

In another aspect, the invention proposes a method of training a controller module to process description data, when the controller module is conditioned on pattern data, to generate first adjustment data for the description data in accordance with controller module parameters. The pattern data relates to a patterned portion of a substrate, and the description data characterizes a model of the patterned portion of the substrate or of at least part of a lithographic apparatus operative to produce the patterned portion of the substrate, e.g. a mask of the lithographic apparatus. The method comprises performing one or more training steps. Each training step includes obtaining one or more training sequences of description data. Each training sequence is produced by obtaining training pattern data, generating initial description data for the training pattern data, and obtaining a training sequence of description data items each comprising description data by, at each of a plurality of iterations, updating the current description data. The current description data is updated by: providing the current description data for the training pattern data to an input of the controller module conditioned on the training pattern data to generate first adjustment data to the current description data, randomly selecting second adjustment data to the current description data, and determining a new description data item comprising updated description data based on the current description data and the first and the second adjustment data. The method further comprises updating the controller module parameters based on the obtained one or more training sequences of description data items.

In some implementations, a plurality of training steps may be performed, and the randomly selected second adjustment may have multiple components. Each component may have a standard deviation selected based on the training step. For example, for each component, the standard deviation may decrease for later training steps.

In some implementations, updating the controller module parameters based on the obtained sequence of description data items may comprise: generating, using a lithography model, for one or more description data items in the sequence of description data items, respective predicted pattern data, and updating the controller module parameters based on the predicted pattern data.

The lithography model may be an observation model which predicts, based on description data characterising the patterned portion of the substrate, pattern data which is metrology data obtainable by applying a metrology process to the patterned portion of the substrate.

Alternatively, the lithography model may be a production model which predicts, based on description data characterizing a mask, pattern data characterizing a pattern applicable to a portion of a substrate by a lithographic apparatus employing the mask.

In some implementations, updating the controller module parameters based on the predicted pattern data may comprise: determining a cost value associated with each of one or more description data items in the one or more training sequences of description data items based on the respective predicted pattern data, and updating the controller module parameters based on the determined cost values.

The respective cost value associated with each of one or more description data items in the sequence of description data items may be determined based on the respective predicted pattern data and based on the obtained pattern data. Alternatively, when the controller module is configured to generate the first adjustment data conditioned on the training pattern data, on the current description data and on a variable indicating the iteration, the respective cost value associated with each of one or more description data items in the sequence of description data items may be determined based on the respective predicted pattern data, the obtained pattern data, the first adjustment data, the second adjustment data, and on the variable indicating the iteration.

In some implementations, when a plurality of training steps are performed, the controller module may be parametrized by a first set of parameters for one or more earlier training steps and by a second set of parameters for one or more later training steps, wherein the number of parameters in the second set of parameters is larger than the number of parameters in the first set of parameters. More generally, the plurality of training steps may be considered as portioned into a number of subsets (where each subset is a set of one or more consecutive steps, and the subsets do not overlap), and there may be a different corresponding set of parameters for each of the subsets of the training steps.

In some implementations, at each training step, a plurality of training sequences of description data are obtained. In this case, updating the controller module parameters based on the obtained training sequences of description data items may comprise: starting from a first position in the obtained training sequences, determining, for each position in the obtained training sequences, a variance associated with a cost value of each of the training sequences at said position, until a position is reached at which the determined variance satisfies a predefined criterion, and updating the controller module parameters based on the data items of the training sequences until (or at) the position at which the determined variance satisfies the predefined criterion. The determined variance may satisfy the predefined criterion when a magnitude of the determined variance is below a predefined threshold value.

In some implementations, obtaining one or more training sequences of description data may comprise obtaining a first plurality of training sequences of description data, determining a variance associated with the first plurality of training sequences of description data items, and obtaining a second plurality of training sequences of description data. In these cases, a length of each of the sequences in the second plurality of training sequences of description data items is selected based on said variance, and the controller module parameters are updated based on the second plurality of training sequences of description data items.

Advantageously, the proposed method of training the controller module does not rely on the gradient of the relevant key performance indicators or error functions. This means that no gradient computation in the solution space is required. This means that non-differentiable state representation can be used for the description data. Further, the controller module learns to provide non-greedy paths to the solution manifolds with lower cost values, in contrast to methods relying on gradient descent on the objective function. Moreover, the proposed method of training the controller module does not rely on ground truth data (e.g. pairs of corresponding pattern data and description data) which is normally expensive or impossible to obtain.

In the explanation given above, the invention is expressed as a method, with various optional features. However, in another aspect, the invention proposes a computer program product comprising machine-readable instructions which, when the program is executed by a computer, cause the computer to carry out the method.

In another aspect, the invention proposes a computer system comprising a processor and a data storage device, the data storage device storing program instructions which, when executed by the processor, cause the processor to carry out the methods discussed above.

## BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 illustrates a lithography model;
- Figure 7 illustrates an iterative process of using a controller module in an embodiment of the invention;
- Figure 8 further illustrates the iterative process of Figure 7;
- Figure 9 is a flowchart of a method which is an embodiment of the invention;
- Figure 10 illustrates a cost landscape associated with an inverse problem;
- Figures 11 and 12 illustrate an initialisation of the iterative process of Figure 7;
- Figure 13 illustrates a process of inferring a surface depth map which is an embodiment of the invention;
- Figure 14 illustrates a process of inferring a model of a component of a lithographic apparatus which is an embodiment of the invention;
- Figure 15, which comprises Figures 15A and 15B, illustrates a stack geometry and corresponding metrology data;
- Figure 16 illustrates a process of training a controller module which is an embodiment of the invention; and
- Figure 17 is a flowchart of a process of training a controller module which is an embodiment of the invention.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

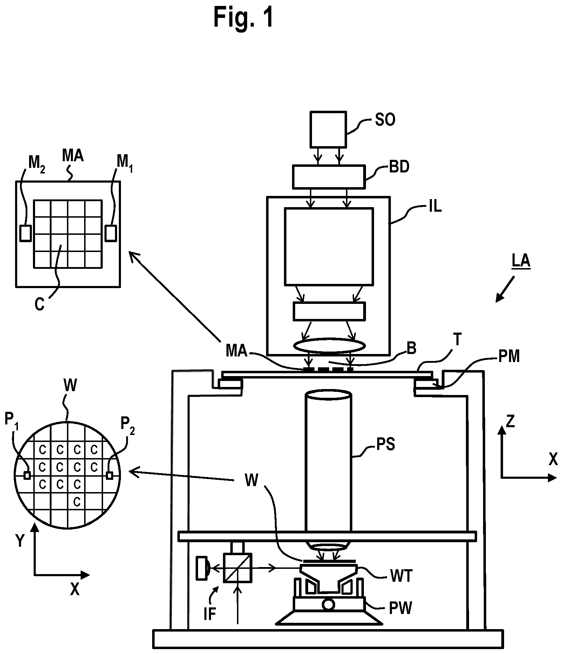

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P 1, P2 as illustrated occupy dedicated target portions, they may be located in spaces between target portions. Substrate alignment marks P 1, P2 are known as scribe-lane alignment marks when these are located between the target portions C.

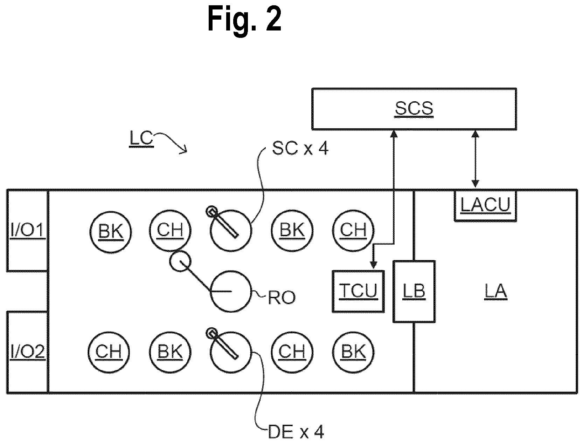

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

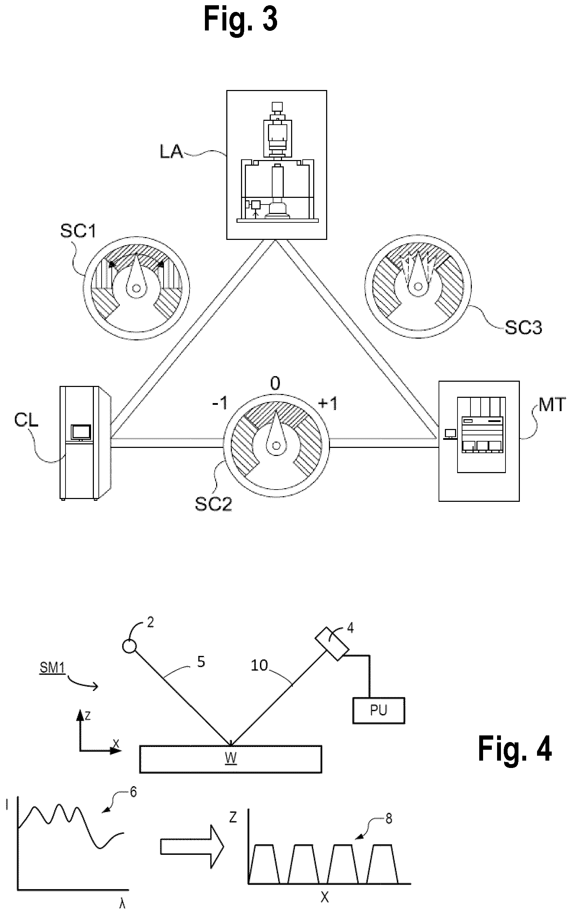

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

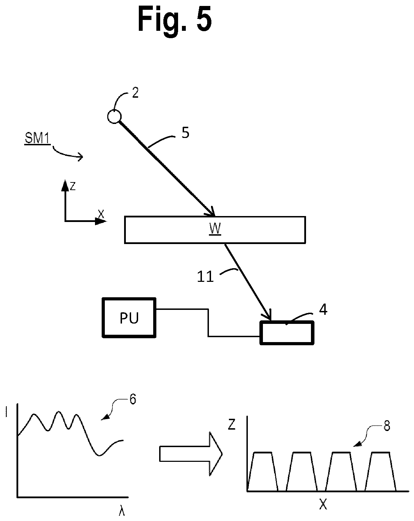

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

In the manufacture of integrated circuits, it is often desirable to be able to solve certain inverse problems, i.e. to be able to determine, from a "target" (e.g. a desired output or an observation), causal factors that produced the target. As one example, in an inverse lithography application, the goal may be to determine a design of a mask (causal factor) that is suitable for forming a desired wafer pattern (target). As another example, it can be helpful to determine from metrology data (target) generated by inspecting a patterned substrate whether the patterned substrate was fabricated correctly (e.g. determining whether the patterned substrate has geometry properties or parameters which are sufficiently close to target design geometry properties or parameters, i.e. whether description data obtained from the pattern data meets a similarity criterion with respect to target design geometry properties or parameters), and/or whether the lithographic apparatus is operating correctly or needs adjustment to one or more control variables of the lithographic apparatus (causal factor). Known metrology systems for inspecting patterned semiconductor wafers include for example optical (e.g. visible light) metrology systems, soft X-ray (SXR) metrology systems, and high landing energy scanning electron microscopy (HL-SEM) systems.

As noted above, iterative optimization based on forward models (e.g. physics-based or trained models) is frequently employed to solve inverse problems, e.g. to infer, from acquired metrology data (target), properties of the patterned substrate (causal factor), e.g. a set of parameters defining a model of the patterned substrate. However, iterative optimization using forward models requires evaluating the forward model a large number of times, which can be computationally and time intensive. Further, these methods are also prone to getting stuck in local minima, i.e. the inferred properties (causal factors) are inaccurate and further iterations do not improve the results, even though a better solution (i.e. a more accurate solution) exists.

Further, iterative optimization using forward models may only solve the associated inverse problem on a instance-by-instance basis, i.e. each target (i.e. data-sample/observation) is handled separately, giving only a "point-estimate" of the solution obtained via gradient descent methods where the relevant key performance indicator (KPI), or objective function, is minimised by following its negative gradient flow. To reduce the computational burden of finding the solution to every instance of the inverse problem, neural network models can be trained to predict solutions of the given problem. This may require either a supervised approach, that might have conflicting data due to the ill-conditioned nature of the problem, or a self-supervised approach that back-propagates the gradient of the objective function to update the weights of the neural network.

In general, while methods that rely on the gradient of the objective function may be able to solve an instance of an inverse problem, there are problems associated with such methods. As one example, these methods do not work for non-differentiable objective functions. Similarly, these methods may not be suitable for solutions that are parameterized in a non-differentiable way (for instance, in the aforementioned mask design/synthesis problem, the solutions may be required to be binary (e.g. due to manufacturability constrains) while having curvilinear and differentiable features). Including such characteristics in the definition of the inverse problem may require cumbersome discretization and processing steps or regularization terms imposing soft constraints in the cost that create local minima. Moreover, gradient descent is a greedy approach that will optimize the solution locally. Thus, the optimization can get easily stuck in local minima surrounded by higher cost regions of the objective function. In many relevant applications, it is desirable to use methods that are able to explore beyond local valleys of the cost function to achieve better optimality.

Further, in situations in which the solution is a manifold including multiple equivalent candidates, the many-to-one mapping of a physics-based forward model can cause problematic inconsistencies when such a model is used to generate a training set for a predictive surrogate model. While self-supervision may mitigate some problems associated with these inconsistencies, only point estimates of the solution space are obtainable without further specifying (at least parts of) the solution manifold. Knowledge of the statistics of the solution space is useful for uncertainty estimates and other statistical measures.

The inventors have realised that at least some of the aforementioned problems of solving inverse problems associated with the manufacture of integrated circuits can be solved by providing generative methods that have learnt a good representation of the solution manifold.

More specifically, the inventors have realised that solving relevant inverse problems may be considered to correspond to the challenge of finding areas in a latent space that minimize a corresponding objective function. This latent space, denoted $Z$, encodes possible solutions to a certain inverse problem, i.e. a state $z$ ($z \in Z$) (also referred to as "description data", latent vector or latent representation; often an ordered array of a plurality of numerical values) of this latent space encodes (i.e. describes/specifies) a possible configuration of the "causal factors" of the inverse problem. For example, the latent space $Z$ may encode designs of a mask (e.g. in inverse lithography applications), depth maps of a patterned substrate (e.g. when inferring an elevation profile from SEM images), and the like.

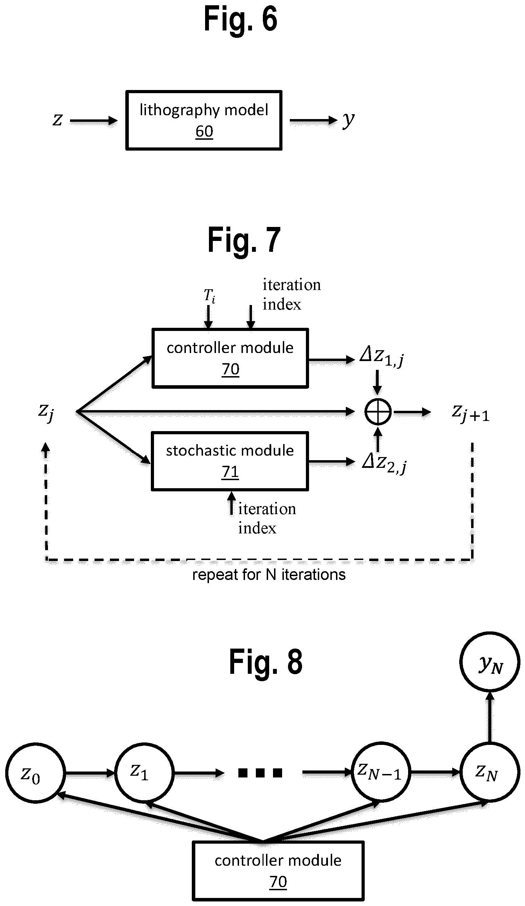

The space (or "domain") of the "target" of the inverse problem may be denoted $Y$, i.e. each data item $y \in Y$ ("pattern data") in the target domain may encode/specify a different configuration of measured or desired data. For example, in the aforementioned inverse lithography application, each state $z$ in the latent space $Z$ may encode a mesh representation of a different mask design. A state of the latent space may be decoded (i.e. mapped) to a vector of the target domain using a lithography model 60, as illustrated in Figure 6. The lithography model 60 is configured to receive, as model input, a state $z$ and to generate, based on the model input, pattern data $y$ which encodes a prediction of a configuration in the target domain (e.g. the pattern data $y$ may be a prediction of metrology data of a patterned substrate when the state $z$ represents a depth map of the patterned substrate, or the pattern data $y$ may be a prediction of a wafer pattern formed by a lithographic process when the state $z$ represents a mesh representation of a mask design, etc.).

Similar to the aforementioned forward models, the lithography model 60 may be a physics-based computational model (e.g. a physical lithographic model in the aforementioned inverse lithography application) or a trained computational model (e.g. a neural network defined by learnable parameters).

With reference to Figure 7 to 9, a process of sampling solutions to a given inverse problem will now be described. In broad terms, the described process enables sampling areas in the latent space $Z$ that minimize a certain objective function (i.e. finding states in the latent space $Z$ that present optimal solutions to a given inverse problem) by using a stochastic process in which an initial guess of the solution is iteratively improved. Thus, the encoding of the solution may be viewed as a state-space representing a multivariate hidden stochastic process, $\{z_k\}$, $k \in [0, N]$ for a "time horizon" $N$. This means that the problem of finding solutions to a given inverse problem may be formulated as a stochastic optimal control problem.

At an initial step S901, pattern data $T_i$ is obtained. The pattern data $T_i$ represents the "target" of an inverse problem of interest. In general, the pattern data $T_i$ is informative about (e.g. describes) a patterned portion of a substrate. Depending on the specific application, the pattern data may comprise acquired data, e.g. metrology data of a patterned substrate, or may comprise data specifying a desired target structure (i.e. design data of a structure that is intended to be formed using a lithographic apparatus). A goal of the process described with reference to Figures 7 to 9 is to determine (or sample) a state $z$ that is consistent with the pattern data $T_i$, i.e. a state $z$ that would (or would have) caused the pattern data $T_i$.

To this end, an initial guess of the "solution", denoted $z_0$ ("initial description data"), is generated (S902), and iteratively improved over a plurality of N iterations. The initial guess $z_0$ can be obtained in any suitable manner, e.g. the initial guess $z_0$ may be generated based on the pattern data $T_i$, or randomly selected.

In each of the N iterations, steps S903-S905 are performed. In broad terms, a single performance of the set of steps S903-S905 implements a "time step" of a stochastic process that generates, from current description data $z_j$, updated description data $z_{j+1}$ ($0 \leq j \leq N - 1$). Thus, the first iteration ($j = 0$), the candidate description data is the initial guess $z_0$; and in the last iteration ($j=N-1$) description data is obtained which is the result of the method. More specifically, at step S903, a trained controller module 70 (illustrated in Figure 7) is used to generate first adjustment data $\Delta z_{1,j}$ to the current description data $z_j$ based on the pattern data $T_i$, the current description data $z_j$, and (preferably) on a variable/index indicating the iteration ("iteration index").

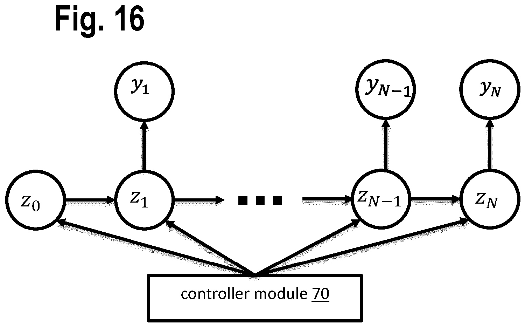

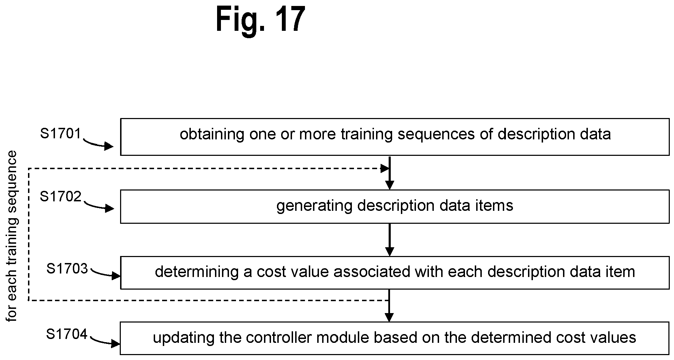

The controller module 70 is a computational model defined by a plurality of learnable/tuneable numerical parameters (e.g. at least 10, at least 100, at least 1000, or more numerical parameters). The controller module 70 may be of any suitable architecture, e.g. controller module 70 may be a linear feedback controller or may comprise one or more neural networks (e.g. to represent complex feedback controllers). The numerical parameters of the controller module 70 have been adjusted based on training data. An example process for training the controller module 70 is described further below with reference to Figures 16 and 17.

In general, the controller module 70 is configured to implement a control function $u(z|T)$ that receives, as input, at least a state $z$ from the latent space and a target state T from the target space (e.g. pattern data $T_i$), and processes the input to generate adjustment data $\Delta z$ which can be combined with the input state $z$ to determine an updated state (i.e. a state is different than the input state). Thus, the first adjustment data $\Delta z_{1,j}$ generated at step S903 may be expressed as $\Delta z_{1,j} = u(z_j|T_i)$. As described in more detail further below with reference to Figures 16 and 17, the controller module 70 has learnt to generate the first adjustment data $\Delta z_{1,j}$ such that combining the input state with the first adjustment data brings the state closer to a region $S_i$ of the latent space that corresponds to a target state $y$ in the target space which minimizes a value of an objective function. In broad terms, this objective function, denoted $E(y, T_i)$, measures a similarity (according to a suitable similarity metric, e.g. a Euclidean distance) between an input target state $y$ from the target space and the target $T_i$. The objective function $E(y, T_i)$ may be evaluated using the lithography model 60. More specifically, the lithography model 60 may be used to "decode" a state $z$ from the latent space (i.e. to map state $z$ to the target space) to generate decoded target state $y(z)$. Thus, the objective function $E(y, T_i)$ can be evaluated for a state $z$ from the latent space by first mapping the state $z$ to target state $y(z)$ in the target space using the lithography model 60, and then evaluating the objective function $E(y(z), T_i)$ using the decoded state $y(z)$ and the target $T_i$. One can identify $F(y(z), T_i)$ as the negative log-likelihood function, and if so the distribution of target states $y(z)$ corresponds to the posterior over parameters encoding solutions of the inverse problem.

At step S904, a random perturbation to the current description data $z_j$ is generated. More specifically, a stochastic module 71 is used to randomly select second adjustment data $\Delta z_{2,j}$. The stochastic module 71 may select a random number for each of a plurality of elements of the second adjustment data $\Delta z_{2,j}$, and may generate the second adjustment data $\Delta z_{2,j}$ based on the selected random numbers. For example, each random number may be sampled from a Gaussian distribution with a predefined standard deviation. In some cases, the stochastic module 71 may receive as input the current description data $z_j$, and may generate the second adjustment data $\Delta z_{2,j}$ based on the current description data $z_j$ (e.g. the stochastic module 71 may select the standard deviation of the Gaussian distributions from which the random numbers are sampled based on the current description data $z_j$). Thus, the second adjustment data $\Delta z_{2,j}$ may be expressed as $\Delta z_{2,j} = W(z_j)$, where $W(z_j)$ denotes a stochastic process, e.g. Gaussian noise.

At step S905, updated description data $z_{j+1}$ is generated based on the current description data $z_j$, the first adjustment data $\Delta z_{1,j}$ and the second adjustment data $\Delta z_{2,j}$. The updated description data $z_{j+1}$ may be generated by additively combining (i) a function (e.g. a linear function) of the first adjustment data, (ii) a function of the second adjustment data and (iii) a function of the current description data. As one example, the updated description data $z_{j+1}$ may be generated based on $z_{j+1} = z_j + \Delta z_j$ where $\Delta z_j$ is given by

$$\Delta z_j = f(j, z_j) + g(j, z_j) * \left( u(z_j|T_i) + W(z_j) \right) \quad \text{(Eq. 1)}$$

where $f(j, z_j)$ and $g(i, z_j)$ are functions of the iteration index $j$ and the the current description data $z_j$ (in Eq. 1, the first and second adjustment data are expressed respectively as $u(z_j|T_i)$, and $W(z_j)$). In other cases, the functions $f(j, z_j)$ and $g(i, z_j)$ may not be needed, and $\Delta z_j$ may be given by

$$\Delta z_j = u(z_j|T_i) + W(z_j) \quad \text{(Eq. 2)}.$$

As illustrated in Figure 8, by performing steps S903-905 for N iterations, a stochastic process is implemented in which the initial description data $z_0$ is iteratively steered towards the optimal solution, i.e. region $S_i$ of the latent space. At each iteration of the process, the current description data is both i) randomly perturbed (by the stochastic module 71) and ii) intelligently guided (by the controller module 70) towards the region $S_i$. Thus, during the stochastic process, the controller module 70 steers the description data from an initial guess to areas where the objective function $E(y, T_i)$ is minimized, resulting in solutions of the inverse problem. In other words, given a specific instance of the inverse problem $T_i$ and a state $z_j$, the controller module 70 "knows" how to steer the process to arrive that the solution manifold.

The final description data is the updated description data $z_N$ after the N-th iteration ($j = N - 1$). The final description data $z_N$ is a sample of the inverse problem defined by the target $T_i$. This means that mapping the final description data $z_N$ to the target space, using the lithography model 60, results in a target state $y_N$ that is equal to, or at least meets a similarity criterion with respect to, the target $T_i$, i.e. $y_N \approx T_i$. The number of iterations $N$ may be pre-defined, or the iterative process may terminate when another termination criterion is met, e.g. that the similarity criterion is met, e.g. that the objective function $E(y, T_i)$ is below a threshold.

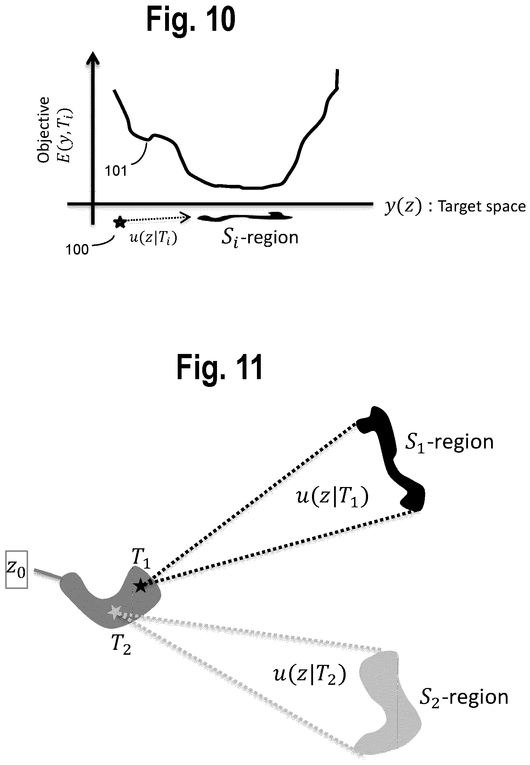

The effect of the guidance provided by the controller during the described stochastic process is illustrated in Figure 10 which shows a plot of an example objective function $E(y, T_i)$. The global minimum of the objective function $E(y, T_i)$ corresponds to the region $S_i$ of the latent space. As can be seen, the "guidance" $u(z|T_i)$ provided by the controller module 70 pushes the current state of the latent space (indicated with the reference numeral 100) towards to the region $S_i$, i.e. the global minimum of the objective function $E(y, T_i)$, regardless of the local minimum 101 of the objective function $E(y, T_i)$.

Thus an advantage of the process described with reference to Figures 7 to 10 is that the described process can overcome local minima of the objective function $E(y, T_i)$ by "tunnelling" through high cost regions (since the described process implements a non-greedy approach). This 'tunnelling effect' results in a better exploration of the solution space and the ability to target multi-mode or complex shaped solution distributions. Another advantage of the described process is that the process does not require gradient information of the relevant KPI/objective function $E(y, T_i)$ (neither during inference nor during training of the controller module 70, as described in more detail further below with reference to Figure 17).

In some implementations, the process described with reference to Figures 7 to 10 may be performed a plurality of times for the same target $T_i$ to generate a corresponding plurality of samples of the region $S_i$. This plurality of samples of the region $S_i$ approximates the solution manifold and can be more informative than a single sample. For example, the plurality of samples of the region $S_i$ can be used to determine an uncertainty associated with the samples/solution. For example, when each sample (point in the region $S_i$) is defined by respective values of a set of numerical components, the uncertainty may be defined as a sum of respective standard deviations of the numerical components of randomly chosen points in the region $S_i$. This uncertainty can be estimated using the plurality of samples of the region $S_i$.

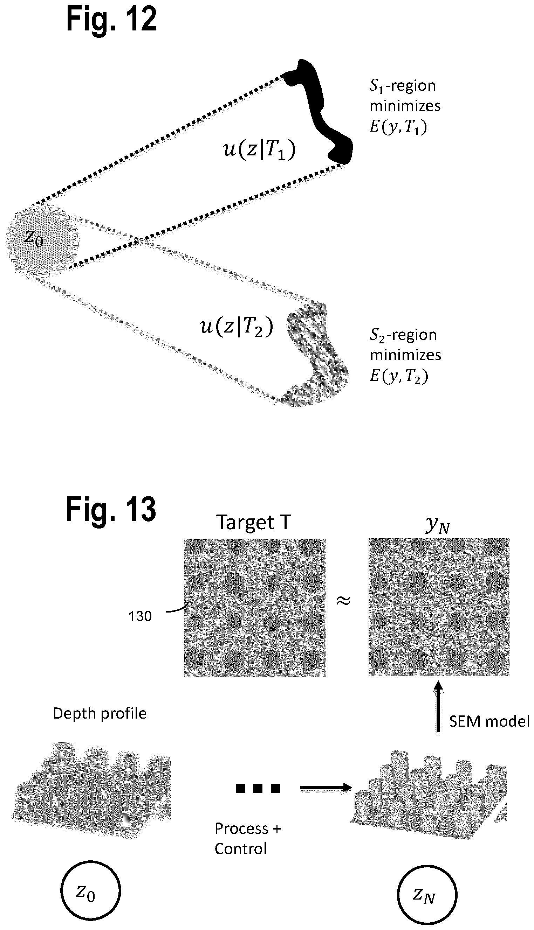

Figures 11 and 12 illustrate different possibilities of initializing the first guess solution $z_0$ ("initial description data") (S902). One possibility is to choose $z_0$ to be equal to the target state. This is illustrated in Figure 11 which shows different initial guesses $z_0$ for different target states, i.e. $z_0 = T_1$ for a first target state $T_1$, and $z_0 = T_2$ for a second target state $T_1$. Given the respective target states, the controller module 70 then guides the mapping from the initial guesses to the regions $S_1$ and $S_2$ of the latent space which comprise the optimal solution for the target states $T_1$, and $T_2$.

Another possibility is to randomly select the initial guess $z_0$. This is illustrated in Figure 12 which shows that the respective initial guesses for the target states $T_1$, and $T_2$ may be randomly selected from the latent space.

Example applications of the process described above with reference to Figures 7 to 10 will now be described with references to Figures 13 to 15. Figure 13 illustrates an application in which the goal is to estimate a surface depth/elevation map of a wafer given acquired SEM image. Thus, in this application, the SEM image 130 is the target T, and states of the latent space can be represented by an image with (e.g. greyscale) pixel values encoding the depth map. Figure 13 illustrates the iterative optimisation of the surface depth map over N iterations. Figure 13 also shows that the surface depth map obtained in the last iteration $z_N$ when mapped to the target space (i.e. SEM images) using the lithography model 60 (in this case a physics-based SEM model) results in a predicted SEM image $y_n$ that is approximately equal to the target SEM image.

Other encodings of the state of the latent space are possible, e.g. using latent variables that encode the depth map, or other parameterizations of the depth/geometry of the wafer surface like an average unit cell parameterized by depth, angles of slope, widths, etc. In this case, the geometry may be the multivariate state that is perturbed under a stochastic process. This problem of estimating the surface depth/elevation map from a SEM image is highly ill-posed with multiple geometries generating the same image. By repeatedly sampling from the region of the latent space which comprises the optimal solution for the target state, it is possible to extract uncertainty estimates for the obtained solutions.

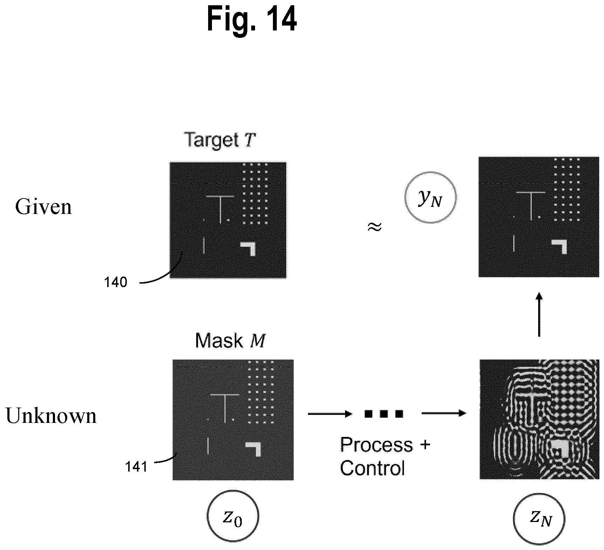

Figure 14 illustrates an "inverse lithography" application in which the aim is to find suitable mask designs given a design layout so that the mask designs optimizes the wafer printing quality measured with KPIs such as edge placement error, or process variation band. Due to manufacturability, the masks may be required to be binary, have curvilinear features and some geometrical constraints captured in Mask Rule Checks (MRCs). Some of these constraints can make the objective function have prohibited regions, local minima and/or be non-differentiable. The data are typically continuous tone masks (CTM) images. However, for sufficient accuracy the resolution required is prohibitive, and the workarounds have cumbersome computations. Since the proposed process does not need gradients of the objective function, the need for a level-set approach as used in some CTM engines to overcome local minima given by regularization terms needed for MRC can be avoided. Instead, the proposed process enables parameterizing the binary mask in terms of points or (curvilinear) shapes. For instance, a ball-representation may be used, so that the stochastic process includes a random walk of the balls or, more generally, of features defined as polygons with control points evolving as stochastic processes. A benefit here is that the mask representation does not need to allow gradient estimates since gradients are not needed.

Figure 14 illustrates the iterative optimisation of a mask design over N iterations. In this example, the target 140 (i.e. the desired design layout) is selected as initial guess 141 of the solution. Again, the "decoded" final state $y_N$ (i.e. the final state $z_N$ mapped to the target space using the lithography model 60) is approximately equal to the target 140.

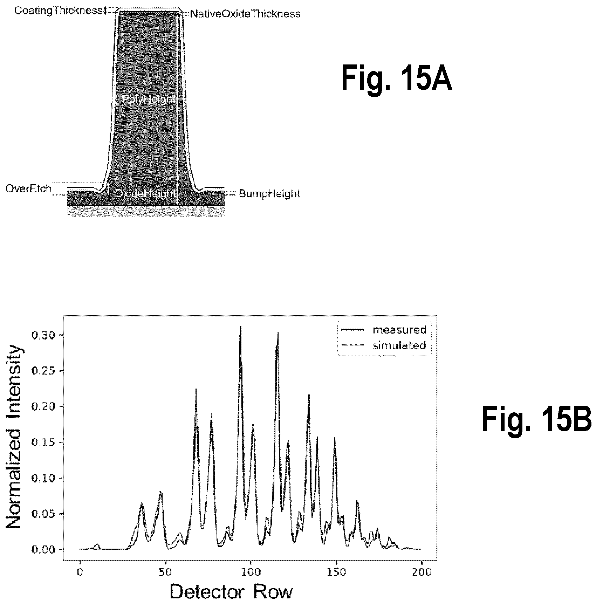

Figures 15A and 15B illustrates an application in which the geometry of a patterned portion of a substrate is inferred from acquired soft X-ray (SXR) data. More specifically, given a SXR spectrogram, the goal is to infer the geometry of the stack or 3D profile on the wafer. Figure 15A shows an example stack. For model-based profilometry, the observation data are scattering spectra that contain information about the profile on the wafer. This can be an image, or a 1D signal if the pattern on the wafer is periodic in one direction. Figure 15B shows an example SXR spectrogram. Typically, there are around 10-20 parameters describing the profile, e.g. heights, angles, widths coating thicknesses, etc. Thus, in this case, an acquired SXR spectrogram corresponds to the target T, and the states of the latent space specify values of the parameters of the model of the profile. One of the challenges in SXR model-based profilometry is the existence of multiple local minima due to the almost periodic behavior of the objective function. The above-described process can overcome this by tunneling between different high cost regions in the parameter space. In some cases, it can be helpful to estimate the initial guess of the solution using physics/optics-based reasoning.

The training of the controller module 70 will now be described. As noted above, in general, the controller module 70 is trained to steer the description data from an initial guess to areas where the objective function is minimized, resulting in solutions of the inverse problem. The inventors have realised that, to this end, the controller module 70 can be trained using path-integral stochastic optimal control techniques. This enables training the controller module 70 to generate first adjustment data which minimize a cumulative cost within a specified time-horizon, as described below in more detail. Before describing specific steps of the training process, a description of the relevant path-integral stochastic optimal control framework is provided.

As noted above, the inference of solution to an inverse problem can formulated as stochastic process. In particular, the stochastic system defined by Eq. (1) can be expressed using a continuous time variable $s$ (with $t \leq s \leq T$; note that here $T$ denotes a time rather than a target) to read:

$$\mathrm{dz}(s) = f\big(s, z(s)\big)ds + g\big(s, z(s)\big) * \big(u(s, z(s)|T_i)ds + dW(z)\big) \qquad \text{(Eq. 3)}$$

where the symbol "d" indicates infinitesimal variations of the respective variables, and, as described above, $z$ denotes a state of the latent space, $u(:)$ denotes the controller module, $T_i$ the target, $W(z)$ denotes a random perturbation (e.g. Gaussian noise), and $f(:)$ and $g(:)$ denote arbitrary functions.

Given the function $u(s, z|T_i)$ that defines, for a given target $T_i$, the control for each state $z$ and each time $t \leq s \leq T$, a cost can be defined as

$$\mathrm{S}(\mathrm{t}, \mathrm{z}, \mathrm{u}, T_i) =$$
$$\int_t^T \left( E\big(s, y\big(z(s)\big), T_i\big) + \tfrac{1}{2} u(s, z(s)|T_i)^2 \right) ds + \int_t^T u(s, z(s)|T_i)\, dW(s) \quad \text{(Eq. 4)}$$

where t and z are the current time and state, and $E(s, y(z(s)), T_i)$ is the aforementioned objective function which measures a similarity between the decoded state $y(z(s))$ and the target $T_i$. The stochastic optimal control problem is to find the optimal control function $u^*$:

$$J(t, z) = \min_u \mathbb{E}\, \mathrm{S}(\mathrm{t}, \mathrm{z}, \mathrm{u}, T_i)$$

$$u^*(t, z|T_i) = \operatorname*{argmin}_u \mathbb{E}\, \mathrm{S}(\mathrm{t}, \mathrm{z}, \mathrm{u}, T_i),$$

where $\mathbb{E}$ denotes an expectation value with respect of the stochastic process Eq. 3. $J(t, z)$ is called the optimal cost-to-go as it specifies the optimal cost from any intermediate state and any intermediate time until the end time t = T. It is clear from the above, that the optimal control function $u^*$ minimizes the cost-to-go.

It is often hard or impossible to derive the optical control function $u^*(t, z|T_i)$. A cross entropy method can be applied to reformulate a stochastic system in terms of Kullback-Leibler (KL) divergence (H.J. Kappen and H.C. Ruiz, "Adaptive Importance Sampling for Control and Inference", J Stat Phys 162, 1244-1266 (2016)). A near optimal control $\hat{u}$ can then be obtained by minimizing the KL divergence. More specifically, reformulating the stochastic system of Eq. 3 in terms of KL divergence yields:

$$KL(p^*|p_{\hat{u}}) \propto \frac{1}{\Psi(t,z)} \, \mathbb{E}_p e^{-S(\text{t,z,u},T_i)} \int_t^T ds \left( \frac{1}{2}\hat{u}(s,z(s)|T_i)^2 - \hat{u}(s,z(s)|T_i)(u(s,z(s)|T_i) + dW_s/ds) \right)$$

$$(\text{Eq. } 5)$$

where $p^*$ denotes the distribution of trajectories with the optimal control $u^*$, $p_{\hat{u}}$ denotes the distribution of trajectories with the near optimal control $\hat{u}$, and $\Psi(t,z) = \mathbb{E}_p e^{-E(\text{t,z},T_i)}$ is a normalization factor.

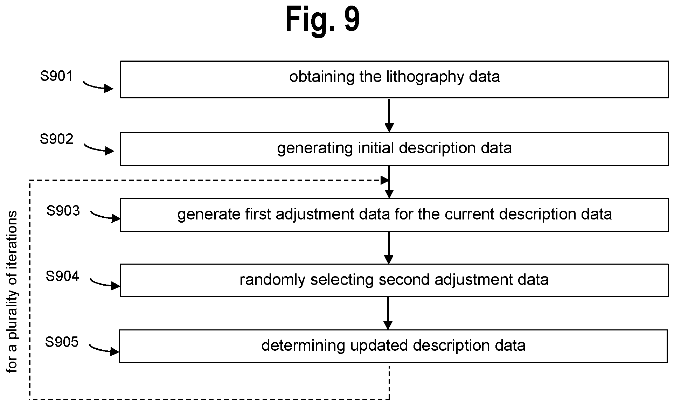

The near optimal control $\hat{u}$ is assumed to be a parametrised function with parameters $\theta$. In the time-dependent case (i.e. when the control depends on the time $s$, i.e. the iteration index in the process of Figure 9), there is a different set of parameters $\theta_s$ for each of the functions $\hat{u}(s, z(s), T_i|\theta_s)$. In this case, the gradient of the KL divergence Eq. 5 is given by:

$$\frac{\partial KL(p^*|p_{\hat{u}})}{\partial \theta_s} =$$

$$\frac{1}{\Psi(t,z)} \, \mathbb{E}_p e^{-S(\text{t,z,u},T_i)} \left( \hat{u}(s,z(s)|T_i) - u(s,z(s)|T_i) - dW_s/ds \right) \frac{\partial \hat{u}(s,z(s)|T_i)}{\partial \theta_s} \qquad (\text{Eq. } 6).$$

In broad terms, the current estimate of the controller can be considered to be a good importance sampler and thus the gradient simplifies to a correlation between the noise and the gradient of the controller. In the case that $\hat{u}(s, z(s)|T_i)$ and $u(s, z(s)|T_i)$ are linear combinations of a set of K basis function $h_{sk}(z, T_i)$ with parameters $\theta_{sk}$ and $\theta_{sk}^0$ respectively (i.e. $\hat{u}(s, z(s)|T_i) = \sum_{k=1}^K \theta_{sk} h_{sk}(z, T_i)$ and a similar expression for $u(s, z(s)|T_i)$), the gradient can be set to zero to obtain for each time $s$ a system of K linear equations with K unknowns $\theta_{sk}$:

$$\sum_{l=1}^K \left( \theta_{skl} - \theta_{sl}^0 \right) \langle h_{sl} h_{sk} \rangle = \langle \frac{dW_s}{ds} h_{sk} \rangle, \qquad t \le s \le T \text{ and } k = 1, \dots, K, \qquad (\text{Eq. } 7)$$

where $(F)$ is defined as $\langle F \rangle = \frac{1}{\Psi(t,z)} \, \mathbb{E}_p e^{-S(\text{t,z,u},T_i)} F$ with $p$ denoting a distribution over trajectories under control $u$ that is linearly parametrized by $\theta^0$. The statistics $\langle h_{sl} h_{sk} \rangle$ and $\langle \frac{dW_s}{ds} h_{sk} \rangle$ can be estimated for all times $t \le s \le T$ from a single Monte Carlo sampling run using the control $u$ parametrized by $\theta^0$. Eq. 7 can be repeated several times, each time with an improved $\theta$ and $u$.

In some implementations, it may be preferable to use a time-independent control function (e.g. when the horizon time is very large, and the dynamics and cost are not explicit functions of time; further a time-independent control function requires typically less storage than a time-dependent control function). In these case, the gradient of the KL divergence Eq. 5 reads

$$\frac{\partial KL(p^*|p_{\hat{u}})}{\partial \theta} =$$

$$\frac{1}{\Psi(t,z)} \, \mathbb{E}_p e^{-S(\text{t,z,u},T_i)} \int_t^T ds \left( \hat{u}(z(s)|T_i) - u(z(s)|T_i) \right) \frac{\partial \hat{u}(z(s)|T_i)}{\partial \theta} + \int_t^T dW(s) \frac{\partial \hat{u}(z(s)|T_i)}{\partial \theta} ) \qquad (\text{Eq. } 7).$$

In general, in cases when the near optimal control $\hat{u}$ does not depend linearly on the parameters $\theta$, one cannot directly solve $\frac{\partial KL(p^*|p_{\hat{u}})}{\partial \theta} = 0$. Instead, a gradient descent procedure may be used. Also in this case, adaptive importance sampling may be used (the KL divergence Eq. 5 is to be minimised with respect to the parameters $\theta$ but also involves a sampling control parametrized by the parameters $\theta^0$). Assuming that the gradient descent procedure improves the control monotonically, it may be advantageous to use the most recent control estimate as sampling control. Setting $\hat{u} = u$, simplifies the gradients for the time-dependent and time-independent cases (Eq. 6 and Eq. 8) so that the gradient updates become respectively

$$\theta_{s,n+1} = \theta_{s,n} - \eta \frac{\partial KL(p^*|p_{\widehat{u}})}{\partial \theta_{s,n}}|_{\widehat{u}=u} = \theta_{s,n} + \eta \left\langle \frac{dW_s}{ds} \frac{\partial \widehat{u}(s, z(s)|T_i)}{\partial \theta_{s,n}} \right\rangle \qquad \text{Eq. 9}$$

$$\theta_{n+1} = \theta_n - \eta \frac{\partial KL(p^*|p_{\widehat{u}})}{\partial \theta_n}|_{\widehat{u}=u} = \theta_{s,n} + \eta \left\langle \int_t^T dW_s \frac{\partial \widehat{u}(z(s)|T_i)}{\partial \theta_n} \right\rangle \qquad \text{Eq. 10}$$

where $\eta > 0$ is a small parameter. Thus, Eq. 6 to 10 provide different update rules for updating the parameters defining the control function depending on implementation details (e.g. time-dependent/independent controller, control function depends linear or non-linear on parameters θ, etc.). These example update rules can be used in the training of the control module 70 as appropriate.

With reference to Figures 16 and 17, a process of training the controller module 70 will now be described. More specifically, the controller module 70 is trained to process description data (i.e. a state target from the latent space), when the controller module is conditioned on pattern data (i.e. a state target from the target space), to generate first adjustment data for the description data in accordance with controller module parameters. The process of training the controller module 70 involves performing one or more training steps.

At each training step, one or more training sequences (or training "trajectories") of description data are obtained (S1701). Each training sequence is obtained by performing the process described above with reference to Figure 9 for a training pattern data item (i.e. a training target state). More specifically, obtaining each training sequence involves obtaining, from a training database, a respective training pattern data item and obtaining a training sequence of description data items (each comprising description data) by performing the stochastic process of Figure 9 to iteratively update an initial guess of the solution over a plurality of iterations. To this end, at each iteration, the controller module 70 processes in accordance with the current values of the controller module parameters an input to the controller module 70 comprising the current description data for the training pattern data, the respective training pattern data and (preferably) a variable indicating the iteration, to generate first adjustment data to the current description data. Then, second adjustment data to the current description data are randomly selected, and a new description data item comprising updated description data based on the current description data and the first and the second adjustment data is determined, as described above. Figure 16 illustrates a training sequence $\{z_0, \dots, z_N\}$.

Steps S1702 and S1703 are then performed for each obtained training sequence. At step S1702, the description data items of the training sequence (or at least one of the description data items, e.g. the final item $z_N$) are decoded by using the lithography model 60, i.e. the lithography model 60 is used to map the description data items of the training sequence to the target space thereby generating a corresponding sequence of decoded states, e.g. $\{y_1, \dots, y_N\}$ (with $y_1 = y(z_1)$, $y_2 = y(z_2)$ and so on), as illustrated in Figure 16. Note that the initial guess $z_0$ may not be decoded, since it is not informative of the state of the controller module 70.

Next, at step S1703, a respective cost value is determined for each of the description data items in the training sequence based on at least the respective decoded description data item of the sequence of decoded description data items $\{y_1, \dots, y_N\}$. The cost value may be determined based on a cost function that depends on the respective decoded description data item and on the corresponding first adjustment data generated for the description data item (in particular, the cost function may be quadratic in the first adjustment data). More specifically, the cost value may be determined based on a cost function that depends on the respective decoded state (i.e. predicted pattern data), the target state (i.e. obtained pattern data), the first adjustment data, the second adjustment data, and on the variable indicating the iteration. Further, the cost value associated with a description data item may be determined not only based on this description data item but also based on all (or some) of the later data description data items in the sequence, e.g. the cost value associated with description data item $z_k$ may be determined based on $z_k$ and based on all (or some) of the later data description data items in the sequence $\{z_{k+1}, \dots, z_N\}$. This allows the controller module to learn to "see" the cost landscape of the problem at any specific moment in time/at any specific iteration. The cost function may be $S(t, z, u, T_i)$ as defined above in Eq. 4.

At step S1704, the values of the parameters of the controller module 70 are updated (i.e. adjusted) based on the obtained one or more training sequences of description data items. More specifically, the parameters of the controller module 70 are updated based on the obtained cost values associated with the description data items of the training sequences. The parameters of the controller module 70 may be updated based on one or more of the above-described update rules defined in Eq. 6 to 10.

The set of steps S1701 to S1704 may be repeated until a termination criterion is met, e.g. the set of steps has been performed a certain number of times, or an update to the controller module in a performance of step S1704 has a magnitude (as measured by some magnitude metric) below a threshold.

An advantage of the training process of Figure 17 is that no "ground truth" data items are required, i.e. the training database does not need to include a training state of the latent space that represents the solution of the inverse problem defined by the training target state. This is achieved by employing techniques from path integral (PI) control theory, e.g. for the generation of the cost values and/or the updating of the parameters defining the controller module.

Several variations of the training process of Figure 17 are envisaged. As one example, when a plurality of training steps are performed, the contribution of the random perturbation may be reduced for later training steps. This means that, for each component of the randomly selected second adjustment which has multiple components, the corresponding standard deviation is decreased for later training steps. This can speed up the overall training process since this encourages the generation of diverse trajectories and the exploration of the cost landscape during an early phase of the training in which the controller module has not yet learnt the details of the cost landscape (initially, the parameters of the controller module may be randomly initialized or initialized based on expected values).

Further, in some implementations of S1703, observations of the cost function are sparse, e.g. step S1703 may only be performed for the last description data item $z_N$, in which case the cost value may be generated based on a discrepancy between the decoded final state and the training target. Alternatively, observations of the objective function could happen every pre-defined amount of time/process steps, or at randomly selected times. In this case, at step S1704, the paths will be penalized by their observation history and the controller module learns to steer the process along the minimizing paths.

Further, the complexity of the controller module may be increased during the training, e.g. a simpler controller module (defined by only a few parameters, e.g. a linear feedback controller) may be used during an early phase of the training (i.e. one or more earlier training steps) and a more complex controller module (defined by a larger number of parameters) during a later phase of the training (i.e. for one or more later training steps). It is to be understood that, in this case, different update rules may be used during the training (e.g. a linear feedback controller may be updated based on Eq. 7 while a more complex controller module, used later in the training, may be updated based on the more general update rule of Eq. 6).

In another variation of the training process of Figure 17, the "effective sample size" is tracked and the parameters of the controller module are only updated until the effective sample size is below a predefined threshold value. This encourages the controller module to learn increasingly accurate approximations of the infinite horizon problem that defines the stationary process describing the distribution of solutions. The term "effective sample size" refers to a measure of the variation of the cost values of each of the training sequences at a given position (i.e. a given iteration). Thus, in some implementations, the training process involves, starting from a first position in the obtained training sequences, determining, for each position in the obtained training sequences, a variance associated with the cost value of each of the training sequences at said position, until a position is reached at which the determined variance satisfies a predefined criterion. The controller module parameters may then be updated based on the data items of the training sequences until the position at which the determined variance satisfies the predefined criterion (i.e. when a magnitude of the determined variance is below a predefined threshold value).

In general, the effective sample size is a very sensitive measure of the disagreement between the learnt generative process and the true distribution defined by the cost landscape. Tracking the effective sample size, provides therefore a sensitive measure for detecting unseen or out-of-distribution targets. This is because the controller will not know how to steer the process to minimize the loss, and as a result, the effective sample size will collapse (in general, the effective sample size collapses when only one sample contributes meaningfully to an Monte-Carlo estimate of the optimal control function $u^*$ or the cost-to-go $J(t, z)$). In some implementations, the effective sample size may be determined during inference, e.g. to determine whether the pattern data represents an in-distribution or an out-of-distribution target (e.g. to filter out/discard description data predicted from pattern data representing out-of-distribution targets).

Thus, in some implementations, the effective sample size is tracked for a first set of training sequences, and the training method further involves obtaining a second set of training sequence of description data, wherein the length (i.e. the number of iterations) for the sequences of the second set of training sequence of description data is selected based the effective sample size tracked for the first set of training sequences. This can lead to a more efficient training process because the length of the training sequences in the second set is selected based on the effective sample size which represents a current understanding of cost landscape by the controller module (i.e. the selected length is neither too long nor too short).

Further embodiments of the invention are disclosed in the list of numbered clauses below:

1. A method of processing pattern data to generate description data, wherein the pattern data is informative about a patterned portion of a substrate, and the description data characterizes a model of the patterned portion of the substrate or of a lithographic apparatus operative to produce the patterned portion of the substrate, the method comprising: i) obtaining the pattern data; ii) generating initial description data; and iii) at each of a plurality of iterations, updating the current description data by: providing the current description data to an input of a trained controller module conditioned on the pattern data to generate first adjustment data to the current description data; randomly selecting second adjustment data to the current description data; and determining updated description data based on the current description data and the first and the second adjustment data.

2. The method of clause 1, wherein determining updated description data based on the first and second adjustment data comprises determining the updated data by additively combining (i) a function of the first adjustment data, (ii) a function of the second adjustment data and (iii) a function of the current description data.

3. The method of clause 1, wherein determining updated description data based on the first and second adjustment data comprises determining the updated description data by additively combining the current description data with the first and the second adjustment data.

4. The method of clause 2 or 3, wherein randomly selecting second adjustment data to the current description data comprises: sampling a random number; determining the second adjustment data based on the random number and based on the current description data.

5. The method of any preceding clause, wherein the trained controller module is conditioned on the pattern data, on the current description data and on a variable indicating the iteration.

6. The method of clause 5, wherein the trained controller module is defined by a plurality of parameters, and the method further comprises, at each iteration, determining, based on the variable indicating the iteration, current values of the plurality of parameters.

7. The method of any preceding clause, wherein the pattern data specifies a desired target structure, and the generated description data characterizes a model of a component of the lithographic apparatus for patterning a portion of a substrate to form the target structure.

8. The method of clause 7 further comprising a step of outputting computer executable instructions for manufacturing a component of the lithographic apparatus based on the generated description data.

9. The method of clause 8 further comprising a step of forming the component for the lithographic apparatus based on the generated description data.

10. The method of any one of clauses 7 to 9, wherein the generated description data characterizes a model of a mask of the lithographic apparatus for patterning a portion of a substrate to form the target structure.

11. The method of any one of clauses 1 to 6, wherein the pattern data comprises metrology data of the patterned portion, and the generated description data specifies predicted information characterizing the patterned portion.

12. The method of clause 11 in which the predicted information is a depth map of the patterned portion.

13. The method of clauses 11 or 12, wherein the metrology data comprises image data.

14. The method of any of clauses 11 to 13, wherein the metrology data comprises data obtained using optical metrology.

15. The method of any preceding clause, wherein the controller module implements a parametrized linear feedback controller.

16. The method of any one of clauses 1 to 14, wherein the controller module comprises at least one neural network.

17. The method of any preceding clause, wherein the initial description data is generated based on the pattern data.

18. The method of any one of clauses 1 to 17, wherein the initial description data is randomly selected.

19. A method of training a controller module to process description data, when the controller module is conditioned on pattern data, to generate first adjustment data for the description data in accordance with controller module parameters, wherein the pattern data is informative about a patterned portion of a substrate, and the description data characterizes a model of the patterned portion of the substrate or of a lithographic apparatus operative to produce the patterned portion of the substrate, the method comprising: performing one or more training steps, at each training step: (i) obtaining one or more training sequences of description data by, for each training sequence: obtaining training pattern data; generating initial description data for the training pattern data; and obtaining a training sequence of description data items each comprising description data by, at each of a plurality of iterations, updating the current description data by: providing the current description data for the training pattern data to an input of the controller module conditioned on the training pattern data to generate first adjustment data to the current description data; randomly selecting second adjustment data to the current description data; and determining a new description data item comprising updated description data based on the current description data and the first and the second adjustment data; and (ii) updating the controller module parameters based on the obtained one or more training sequences of description data items.

20. The method of clause 19, wherein a plurality of training steps are performed, and the randomly selected second adjustment has multiple components, each component having a standard deviation selected based on the training step.

21. The method of clause 20, wherein, for each component, the standard deviation decreases for later training steps.

22. The method of any one of clauses 19 to 21, wherein updating the controller module parameters based on the obtained sequence of description data items comprises:

generating, using a lithography model, for one or more description data items in the sequence of description data items, respective predicted pattern data, and
updating the controller module parameters based on the predicted pattern data.

23. The method of clause 22 in which the lithography model is an observation model which predicts, based on description data characterising the patterned portion of the substrate, pattern data which is metrology data obtainable by applying a metrology process to the patterned portion of the substrate.

24. The method of clause 22 in which the lithography model is a production model which predicts, based on description data characterizing a mask, pattern data characterizing a pattern applicable to a portion of a substrate by a lithographic apparatus employing the mask.

25. The method of any of clauses 22 to 24, wherein updating the controller module parameters based on the predicted pattern data comprises: determining a cost value associated with each of one or more description data items in the one or more training sequences of description data items based on the respective predicted pattern data, and updating the controller module parameters based on the determined cost values.

26. The method of clause 25, wherein the respective cost value associated with each of one or more description data items in the sequence of description data items is determined based on the respective predicted pattern data and based on the obtained pattern data.

27. The method of clause 25, wherein the controller module is configured to generate the first adjustment data conditioned on the training pattern data, on the current description data and on a variable indicating the iteration, and the respective cost value associated with each of one or more description data items in the sequence of description data items is determined based on the respective predicted pattern data, the obtained pattern data, the first adjustment data, the second adjustment data, and on the variable indicating the iteration.

28. The method of any one of clauses 19 to 27, wherein a plurality of training steps are performed, and the controller module is parametrised by a first set of parameters for one or more earlier training steps and by a second set of parameters for one or more later training steps, wherein the number of parameters in the second set of parameters is larger than the number of parameters in the first set of parameters.

29. The method of any one of clauses 19 to 28, wherein at each training step, a plurality of training sequences of description data are obtained, and updating the controller module parameters based on the obtained training sequences of description data items comprises:

starting from a first position in the obtained training sequences, determining, for each position in the obtained training sequences, a variance associated with a cost value of each of the training sequences at said position, until a position is reached at which the determined variance satisfies a predefined criterion, and updating the controller module parameters based on the data items of the training sequences until the position at which the determined variance satisfies the predefined criterion.

30. The method of clause 29, wherein the determined variance satisfies the predefined criterion when a magnitude of the determined variance is below a predefined threshold value.

31. The method of any one of clauses 19 to 28, wherein said obtaining one or more training sequences of description data comprises obtaining a first plurality of training sequences of description data; determining a variance associated with the first plurality of training sequences of description data items; and obtaining a second plurality of training sequences of description data, wherein a length of each of the sequences in the second plurality of training sequences of description data items is selected based on said variance, and the controller module parameters are updated based on the second plurality of training sequences of description data items.

32. A method according to any of clauses 1 to 18 in which the controller module is a trained by a method according to any of clauses 19 to 31.

33. A computer program product comprising machine-readable instructions which, when the program is executed by a computer, cause the computer to carry out the method of any preceding clause.

34. A computer system comprising a processor and a data storage device, the data storage device storing program instructions which, when executed by the processor, cause the processor to carry out the method of any one of clauses 1 to 31.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of processing pattern data to generate description data, wherein the pattern data is informative about a patterned portion of a substrate, and the description data characterizes a model of the patterned portion of the substrate or of a lithographic apparatus operative to produce the patterned portion of the substrate,
   the method comprising:

   i) obtaining the pattern data;
   ii) generating initial description data; and
   iii) at each of a plurality of iterations, updating the current description data by:
   providing the current description data to an input of a trained controller module conditioned on the pattern data to generate first adjustment data to the current description data;
   randomly selecting second adjustment data to the current description data; and determining updated description data based on the current description data and the first and the second adjustment data.

2. The method of claim 1, wherein determining updated description data based on the first and second adjustment data comprises determining the updated data by additively combining (i) a function of the first adjustment data, (ii) a function of the second adjustment data and (iii) a function of the current description data.

3. The method of claim 1, wherein determining updated description data based on the first and second adjustment data comprises determining the updated description data by additively combining the current description data with the first and the second adjustment data.

4. The method of claim 2 or 3, wherein randomly selecting second adjustment data to the current description data comprises:

   sampling a random number;
   determining the second adjustment data based on the random number and based on the current description data.

5. The method of claim 1, wherein the trained controller module is conditioned on the pattern data, on the current description data and on a variable indicating the iteration.

6. The method of claim 5, wherein the trained controller module is defined by a plurality of parameters, and the method further comprises, at each iteration, determining, based on the variable indicating the iteration, current values of the plurality of parameters.

7. The method of claim 1, wherein the pattern data specifies a desired target structure, and the generated description data characterizes a model of a component of the lithographic apparatus for patterning a portion of a substrate to form the target structure.

8. The method of claim 7, wherein the generated description data characterizes a model of a mask of the lithographic apparatus for patterning a portion of a substrate to form the target structure.

9. The method of claim 1, wherein the pattern data comprises metrology data of the patterned portion, and the generated description data specifies predicted information characterizing the patterned portion.

10. The method of claim 1, wherein the initial description data is generated based on the pattern data.

11. A method of training a controller module to process description data, when the controller module is conditioned on pattern data, to generate first adjustment data for the description data in accordance with controller module parameters,
    wherein the pattern data is informative about a patterned portion of a substrate, and the description data characterizes a model of the patterned portion of the substrate or of a lithographic apparatus operative to produce the patterned portion of the substrate,
the method comprising:
performing one or more training steps, at each training step:

(i) obtaining one or more training sequences of description data by, for each training sequence:

obtaining training pattern data;
generating initial description data for the training pattern data; and
obtaining a training sequence of description data items each comprising description data by, at each of a plurality of iterations, updating the current description data by:

providing the current description data for the training pattern data to an input of the controller module conditioned on the training pattern data to generate first adjustment data to the current description data; randomly selecting second adjustment data to the current description data; and
determining a new description data item comprising updated description data based on the current description data and the first and the second adjustment data; and

(ii) updating the controller module parameters based on the obtained one or more training sequences of description data items.

12. The method of claim 11, wherein a plurality of training steps are performed, and the randomly selected second adjustment has multiple components, each component having a standard deviation selected based on the training step.

13. The method of claim 11, wherein, for each component, the standard deviation decreases for later training steps.

14. The method of claim 11, wherein updating the controller module parameters based on the obtained sequence of description data items comprises:

generating, using a lithography model, for one or more description data items in the sequence of description data items, respective predicted pattern data, and
updating the controller module parameters based on the predicted pattern data.

15. A computer program product comprising machine-readable instructions which, when the program is executed by a computer, cause the computer to carry out the method of any of claim 1 to 6.

# Fig. 1

# Fig. 2

# Fig. 3

# Fig. 4

# Fig. 5

# Fig. 6

# Fig. 7

repeat for N iterations

# Fig. 8

# Fig. 9

S901 → | obtaining the lithography data |

S902 → | generating initial description data |

S903 → | generate first adjustment data for the current description data |

S904 → | randomly selecting second adjustment data |

S905 → | determining updated description data |

for a plurality of iterations

# Fig. 10

# Fig. 11

# Fig. 12

$u(z|T_1)$

$S_1$-region minimizes $E(y, T_1)$

$z_0$

$u(z|T_2)$

$S_2$-region minimizes $E(y, T_2)$

# Fig. 13

Target T

$y_N$

130

$\approx$

SEM model

Depth profile

Process + Control

$z_0$

$z_N$

# Fig. 14

Given

Target $T$

140

$\approx$   $y_N$

Unknown

Mask $M$

141

$z_0$

Process + Control

$z_N$

Fig. 15A

Fig. 15B

# Fig. 16

controller module <u>70</u>

# Fig. 17

S1701 → obtaining one or more training sequences of description data

for each training sequence

S1702 → generating description data items

S1703 → determining a cost value associated with each description data item

S1704 → updating the controller module based on the determined cost values

Europäisches
Patentamt

European
Patent Office

Office européen
des brevets

# EUROPEAN SEARCH REPORT

**Application Number**

EP 24 21 9103

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2022/233546 A1 (ASML NETHERLANDS BV [NL]) 10 November 2022 (2022-11-10) <br> * the whole document * <br> ----- | 1-15 | INV. <br> G03F7/20 <br> G06N3/047 <br> G06N3/08 <br> G06N20/00 |
| A | WO 2020/193095 A1 (ASML NETHERLANDS BV [NL]) 1 October 2020 (2020-10-01) <br> * paragraph [0068] - paragraph [00111] * <br> * figures 4-7 * <br> * abstract * <br> ----- | 1-15 | |

**TECHNICAL FIELDS SEARCHED (IPC)**

G03F
G06N

The present search report has been drawn up for all claims

| Place of search | Date of completion of the search | Examiner |
|---|---|---|
| Munich | 26 June 2025 | Maslankiewicz, Pawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2025

| Patent document cited in search report | Publication date | Patent family member(s) | | Publication date |
|---|---|---|---|---|
| WO 2022233546 A1 | 10-11-2022 | IL | 308126 A | 01-12-2023 |
| | | TW | 202248884 A | 16-12-2022 |
| | | US | 2024369944 A1 | 07-11-2024 |
| | | WO | 2022233546 A1 | 10-11-2022 |
| WO 2020193095 A1 | 01-10-2020 | CN | 113892059 A | 04-01-2022 |
| | | CN | 120178612 A | 20-06-2025 |
| | | JP | 7256287 B2 | 11-04-2023 |
| | | JP | 7624023 B2 | 29-01-2025 |
| | | JP | 2022524970 A | 11-05-2022 |
| | | JP | 2023089034 A | 27-06-2023 |
| | | JP | 2025076430 A | 15-05-2025 |
| | | KR | 20210130784 A | 01-11-2021 |
| | | KR | 20240132400 A | 03-09-2024 |
| | | TW | 202043938 A | 01-12-2020 |
| | | TW | 202206950 A | 16-02-2022 |
| | | TW | 202316203 A | 16-04-2023 |
| | | US | 2022179321 A1 | 09-06-2022 |
| | | WO | 2020193095 A1 | 01-10-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2007224518 A
- US 2019003988 A1
- US 2019215940 A1
- US 20130304424 A1
- US 2014019097 A1, Bakeman

**Non-patent literature cited in the description**

- **H.J. KAPPEN** ; **H.C. RUIZ**. Adaptive Importance Sampling for Control and Inference. *J Stat Phys*, 2016, vol. 162, 1244-1266